# EUROPÄISCHE PATENTSCHRIFT

(11) **EP 1 536 455 B1**
(45) Veröffentlichungstag und Bekanntmachung des Hinweises auf die Patenterteilung: **16.08.2006**
(21) Anmeldenummer: 04027993.7
(22) Anmeldetag: 25.11.2004
(51) Int. Cl.: H01L 21/00, C23C 14/56

(54) **Vakuumschleusenanordnung**
Vacuum lock arrangement
Arrangement de sas à air sous vide

(30) Priorität: 28.11.2003 DE 10355683
(43) Veröffentlichungstag der Anmeldung: 01.06.2005
(73) Patentinhaber: Singulus Technologies AG, 63796 Kahl/Main (DE)
(72) Erfinder: Kempf, Stefan, 63755 Alzenau (DE); Merz, Thomas, 63739 Aschaffenburg (DE); Mücke, Michael Dr., 61206 Wöllstadt (DE); Runkel, Steffen Dr., 63584 Gründau Lieblos (DE)
(74) Vertreter: Vossius & Partner

(56) Entgegenhaltungen:
- EP-A- 0 344 823
- DE-A1- 4 009 603
- DE-A1- 19 812 670
- DE-A1- 19 816 739

## Beschreibung

Die Erfindung betrifft eine Vakuumschleusenanordnung mit einer Schleuse und einer Kammer für Hochvakuum, die mit der Schleuse verbindbar ist.

Insbesondere betrifft die Erfindung eine Vakuumschleusenanordnung bestehend aus einer Schleuse, einer Transportkammer und zwei Prozeßkammern, die zum Beispiel für eine beidseitige Behandlung von Substraten geeignet ist, und ein Transportverfahren, das mittels der erfindungsgemäßen Anordnung durchgeführt wird. Mindestens ein Substrat wird über die Schleuse in einen Substrathalter eingelegt, der auf einem Substratträger angeordnet ist und durch die Transportkammer zu den Prozeßkammern transportiert wird, wobei in der Transportkammer und in den Prozeßkammern ein Hochvakuum besteht bzw. aufrechterhalten wird.

Derartige Vakuumschleusenanordnungen sind bereits bekannt. Die DE-C1-198 06 282 offenbart eine Vorrichtung mit einer Schleuse, einer Transportkammer und einer Prozeßkammer, bei der ein Substrat über eine Schleuse auf einen Substratträger, der als Hubschwenkträger ausgebildet ist, abgelegt wird und durch die Transportkammer zur Prozeßkammer transportiert wird. Nachdem in der Schleuse ein Vorvakuum erzeugt wurde, wird der Substratträger abgesenkt, um das Substrat in die Prozeßkammer zu transportieren, wobei das Vorvakuum über den Transportraum mit dem Hochvakuum der Prozeßkammer in Verbindung kommt; der dabei auftretende Druckanstieg kann den Prozeß in der Prozeßkammer negativ beeinflussen. Ähnliche Vakuumsysteme sind auch aus der EP-B1-0 443 049 und der EP-B1-0 449 227 bekannt, bei denen die Schleuse mittels eines Stößels durch einen Substrathalter abgedichtet wird, bis in der Schleuse Vorvakuum erzeugt ist. Danach wird die Schleuse zum Transportraum und zur Prozeßkammer geöffnet, so daß das Gas aus der Schleuse in die Prozeßkammer expandieren kann.

Der Erfindung liegt die Aufgabe zugrunde, eine Vakuumschleusenanordnung und ein Transportverfahren mittels dieser Anordnung zur Verfügung zu stellen, wobei ein Druckstoß bzw. ein Druckanstieg in mindestens einer Hochvakuumkammer bei einem weiteren einen Hochvakuumpumpenanschluß durch eine Hochvakuumpumpe abgesaugt. Wenn das Vakuum in der Schleuse annähernd den gleichen Wert wie in der Transportkammer und in den Prozeßkammer erreicht hat, wird der zweite Schleusendeckel von der Schleuse weggefahren, so daß der Substrathalter mit dem zu behandelnden Substrat zum Beispiel durch die Kraft der Feder, die ihn mit dem Substratträger verbindet, oder, wenn die Kammern waagrecht angeordnet sind, nur durch die Schwerkraft auf den Substratträger zurückgezogen wird. Über den noch offenen Hochvakuumkanal sind jetzt die Prozeßkammer, die Transportkammer und die Schleuse mit der Hochvakuumpumpe verbunden und ein geeignetes Hochvakuum kann aufrechterhalten werden. Ein behandeltes Substrat aus den Prozeßkammern kann dann zur Schleuse und umgekehrt das zu behandelnde Substrat zu den Prozeßkammer durch den Drehteller transportiert werden. Die Entnahme des behandelten Substrats erfolgt, nachdem der zweite Schleusendeckel den Substrathalter an die Schleusenöffnung gedrückt hat, der Hochvakuumkanal geschlossen ist und die Schleuse durch ein Ventil belüftet wurde.

Der Vorteil der Erfindung liegt in stabileren Prozeßbedingungen und einer Verbesserung der Qualität bei der Behandlung von zum Beispiel CDs, DVDs, optischen Linsen und Brillengläsern, zum Beispiel bei empfindlichen Beschichtungsprozessen.

Im folgenden wird die Erfindung anhand der Zeichnung näher erläutert. Es zeigen:
- Figur 1: einen Querschnitt durch eine Ausführungsform der erfindungsgemäßen Anordnung, wobei die Verbindung zwischen der Schleuse und der Transportkammer sowie den Prozeßkammer geschlossen ist,
- Figur 2: die Ausführungsform gemäß Figur 1, wobei eine Verbindung zwischen der Schleuse und einer Hochvakuumpumpe hergestellt ist,
- Figur 3: einen vergrößerten Ausschnitt aus Figur 2, und
- Figur 4: die Ausführungsform gemäß Figur 1, wobei eine Verbindung zwischen den Prozeßkammern, der Transportkammer, der Schleuse und der Hochvakuumpumpe hergestellt ist.

Evakuieren einer ihr vorgeschalteten Vorvakuumkammer zuverlässig vermieden wird.

Die Aufgabe wird mit den Merkmalen der Patentansprüche gelöst.

Bei der Lösung geht die Erfindung von folgenden Grundgedanken aus.

Wenn die Schleuse mit der Hochvakuumkammer verbunden werden soll, wird das Hochvakuum in ihr gegen die Schleuse solange abgedichtet, bis auch diese auf Hochvakuum evakuiert ist.

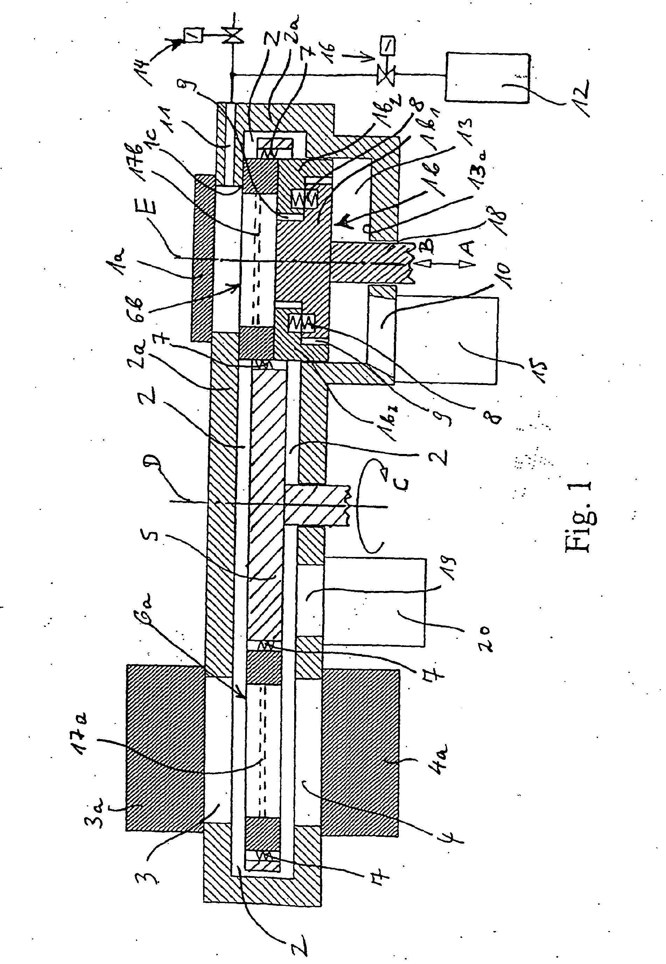

Insbesondere sind zur beidseitigen Behandlung eines Substrats zwei einander gegenüberliegende Prozeßkammern, in denen Hochvakuum erzeugt wird, vorgesehen. Die Prozeßkammern sind durch eine Transportkammer, in der Hochvakuum erzeugt wird, über einen Drehteller, der mindestens einen ersten und zweiten Substrathalter trägt, mit einer Schleuse, verbunden. Die Substrathalter sind z.B. über Zugfedern mit dem Substratträger gekoppelt. Die Schleuse weist einen äußeren ersten und einen inneren zweiten Schleusendeckel auf. Der erste Schleusendeckel verschließt die Schleuse nach außen, und der zweite Schleusendeckel verschließt zusammen mit jeweilig einem Substrathalter den Transportraum und die Prozeßkammern gegen die Schleuse, wenn ein Substrat eingeschleust wird. Dabei drückt der zweite Schleusendeckel den Substrathalter gegen die Kraft der Federn, die den Substrathalter im Substratträger halten, gegen die Öffnung der Schleuse. Der zweite Schleusendeckel ist zweigeteilt, wobei ein erstes Teil über Federn, vorzugsweise Druckfedern mit einem zweiten Teil verbunden ist, so daß die Federn im unbelasteten Zustand zwischen den beiden Teilen einen ringförmigen Hochvakuumkanal offenhalten. Im belasteten Zustand der Federn, d.h. wenn der zweite Schleusendeckel den Substrathalter gegen die Öffnung der Schleuse drückt, ist der Hochvakuumkanal geschlossen. Nach dem Einlegen mindestens eines Substrates in den Substrathalter an der Schleuse wird die Schleuse durch den ersten Schleusendeckel geschlossen und über einen Belüftungs-Vorvakuumpumpenkanal durch eine Vorvakuumpumpe auf Vorvakuum evakuiert. Nach Erreichen eines ausreichenden Vorvakuums wird das erste Teil des zweiten Schleusendeckels entlastet, so daß der Hochvakuumkanal durch die Kraft der Druckfedern zwischen dem ersten und zweiten Teil geöffnet wird, aber die Druckfedern das zweite Teil und den Substrathalter noch an die Öffnung der Schleuse gedrückt halten. Auf diese Weise kann das Gasvolumen aus der Schleuse in den Raum hinter dem zweiten Schleusendeckel expandieren und wird dort über Die Figuren 1 bis 4 zeigen Querschnitte einer Ausführungsform der erfindungsgemäßen Vakuumschleusenanordnung, die vorzugsweise für die beidseitige Behandlung von Substraten vorgesehen ist. Das erfindungsgemäße System weist eine Transportkammer 2 zwischen einer Schleuse 1 und zwei einander gegenüber liegenden Prozeßkammern 3 und 4, an deren Öffnungen Prozeßeinrichtungen 3a bzw. 4a, z.B. Kathodenzerstäubungseinrichtungen, Ionenkanonen oder CVD-Beschichtungseinrichtungen angeordnet sind, auf, die in den Figuren waagrecht angeordnet sind, aber auch anders, z.B. senkrecht stehend, angeordnet sein können. In der Transportkammer 2 ist ein als Drehteller oder Schwenkarm ausgebildeter Substratträger 5 angeordnet, der einen ersten und einen zweiten Substrathalter 6a bzw. 6b trägt und in Richtung des Pfeils C um die Achse D zwischen der Schleuse 1 und den Prozeßkammern 3 und 4 schwenkbar ist. Im Rahmen der Erfindung ist eine Bewegung längs der Achse D nicht erforderlich. Die Substrathalter 6a, 6b sind mittels Zugfedern 7 an dem Substratträger 5 gegen diesen bewegbar angeordnet, wobei sie, wenn die Federn 7 nicht belastet sind, auf dem gleichen Niveau wie der Substratträger liegen. Die Transportkammer 2 weist einen weiteren Hochvakuumpumpenanschluß 19 mit einer Hochvakuumpumpe 20 auf. Die Schleuse 1 weist einen äußeren ersten Schleusendeckel 1a und einen inneren zweiten Schleusendeckel 1b auf. Der innere zweite Schleusendeckel 1b ist bezüglich der Schleuse 1 längs der Achse E in Pfeilrichtung A und B durch eine Kolbenstange 18 verschiebbar. Der zweite Schleusendeckel 1b besteht aus zwei Teilen 1b₁ und 1b₂, die durch Druckfedern 8 miteinander verbunden sind und bei unbelasteten Federn zwischen sich einen ringförmigen Hochvakuumkanal 9 ausbilden. In den Figuren unterhalb des zweiten Schleusendeckels 1b ist ein Hochvakuumpumpenanschluß 10 angeordnet, der mit dem Hochvakuumkanal 9 in Verbindung steht. An dem Hochvakuumpumpenanschluß 10 ist eine Hochvakuumpumpe 15 angeschlossen, die vorzugsweise eine Turbomolekularpumpe ist. Die Schleuse 1 weist einen Belüftungs- und Vorvakuumpumpen-Kanal 11 auf, um die Schleuse 1 entweder über ein Ventil 14 zu belüften oder bei geschlossenem Ventil 14 über ein geöffnetes Ventil 16 durch eine Vorvakuumpumpe 12 zu evakuieren. Der Substrathalter 6b wird durch Vakuumdichtungen (nicht dargestellt) im Bereich der Schleuse gegen die Wand 2a der Transportkammer 2 und das Teil 1b₁ abgedichtet. Vakuumdichtungen (nicht dargestellt) sind auch zwischen dem ersten Teil 1b₁ und dem zweiten Teil 1b₂ des inneren Schleusendeckels angeordnet, um den Hochvakuumkanal 9 zuverlässig zu verschließen, wenn die Schleuse 1 nach außen geöffnet ist oder Vorvakuum erzeugt wird. Anders als in den Figuren können die zwei Prozeßkammern bezüglich der Drehachse D in Azimutrichtung auch gegeneinander versetzt auf beiden Seiten der Transporteinrichtung 5 angeordnet sein, wenn mehr als zwei Substrathalter vorgesehen sind.

Ein Transportverfahren mittels der erfindungsgemäßen Ausführungsform wird im folgenden anhand der Figuren 1 bis 4 näher erläutert.

Ausgehend von der Darstellung von Figur 1 wird nach Abheben des ersten Schleusendeckels 1a von der Schleuse 1 mindestens ein Substrat 17b in den zweiten Substrathalter 6b abgelegt. Danach wird die Schleuse 1 mit dem ersten Deckel 1a wieder verschlossen. Der zweite Substrathalter 6b wird über die axial verschiebbare (Pfeil B) Kolbenstange 18 und die beiden Teile 1b₁ und 1b₂ des inneren Schleusendeckels, d.h. den zweiten Schleusendeckel 1b gegen die Kraft der Zugfedern 7 an die Öffnung 1c der Schleuse 1 abdichtend gedrückt. Der Hochvakuumkanal 9 im zweiten Schleusendeckel 1b wird gegen die Kraft der Druckfedern 8 mit Hilfe der Kolbenstange 18 und dem Schleusenteil 1b₁, die in Richtung des Pfeils B (in der Zeichnung nach oben) gedrückt werden, verschlossen. Die Schleuse 1 ist somit gegen die Transportkammer 2, und damit auch gegen die Prozeßkammer 3 und 4, und gegen den Raum 13 hinter dem zweiten Schleusendeckel 1b mit dem Hochvakuumpumpenanschluß 10 abgeschlossen. Der erste Substrathalter 6a befindet sich zwischen den Prozeßkammern 3 und 4, so daß das Substrat 17a einseitig und vorzugsweise von beiden Seiten gleichzeitig oder nacheinander behandelt werden kann. Auf diese Weise können zum Beispiel CDs, DVDs, optische Linsen oder Brillengläser beschichtet oder zum Beispiel durch Sputterätzen gereinigt werden.

Die Schleuse 1 wird bei geschlossenem Ventil 14 und geöffnetem Ventil 16 über den Kanal 11 durch die Vorvakuumpumpe 12 auf ein Vorvakuum von z.B. 0,1 bis 3 mbar, vorzugsweise 1 mbar evakuiert. Dieser Zustand ist in Figur 1 dargestellt.

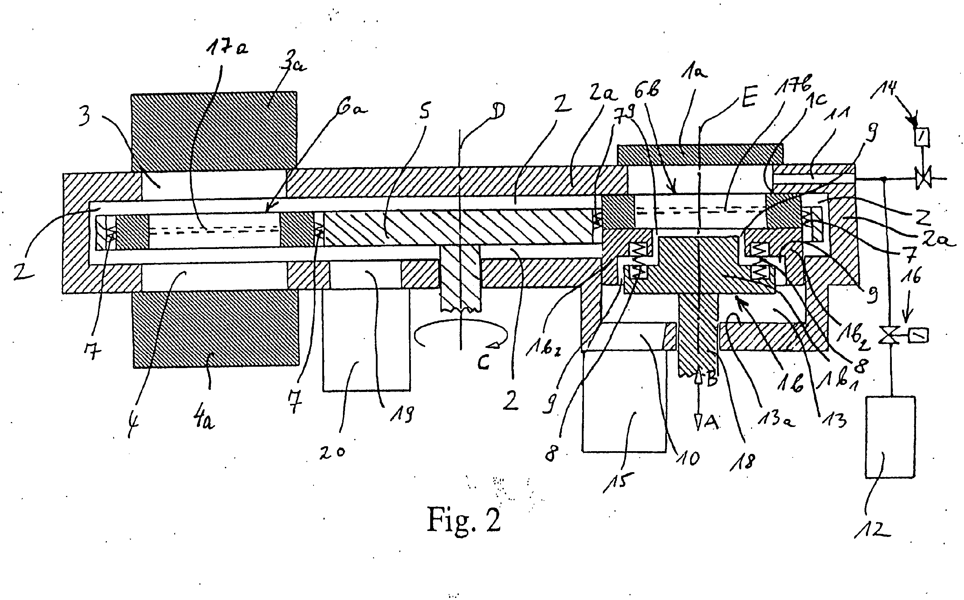

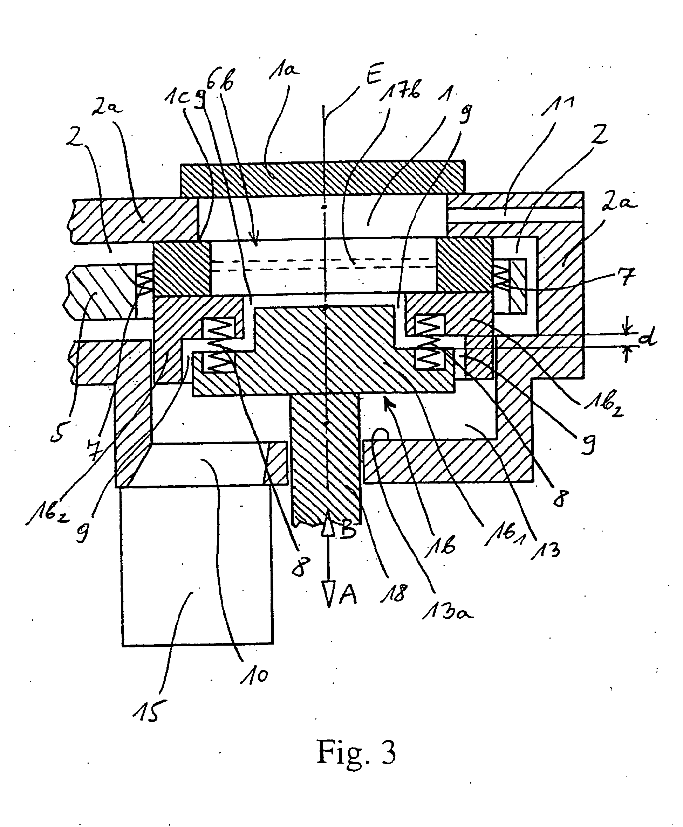

Nach Erreichen des Vorvakuums in der Schleuse 1 wird das Ventil 16 geschlossen und danach das erste Teil 1b₁ des zweiten Schleusendeckels 1b in Pfeilrichtung A nach unten soweit abgesenkt, daß sich der Hochvakuumkanal 9 um eine Spaltbreite d öffnet, so daß das Gasvolumen aus der Schleuse 1 in den Raum 13 hinter dem Schleusendeckel 1b expandiert und über den Hochvakuumpumpenanschluß 10 durch die Hochvakuumpumpe 15 abgesaugt wird. Der zweite Teil 1b₂ des zweiten Schleusendeckels 1b hält durch die Druckkraft der zweiten Federn 8 den zweiten Substrathalter 6b weiterhin abdichtend an die Öffnung 1c der Schleuse, so daß die Transportkammer 2 und die Prozeßkammern 3 und 4 weiterhin verschlossen bleiben und sich die Vakuumbedingungen dort nicht ändern. Dieser Zustand ist in den Figuren 2 und 3 dargestellt, wobei die Figur 3 den Bereich der Schleuse mit dem ringförmigen Hochvakuumkanal 9 mit der Spaltbreite d gegenüber Fig. 2 vergrößert zeigt.

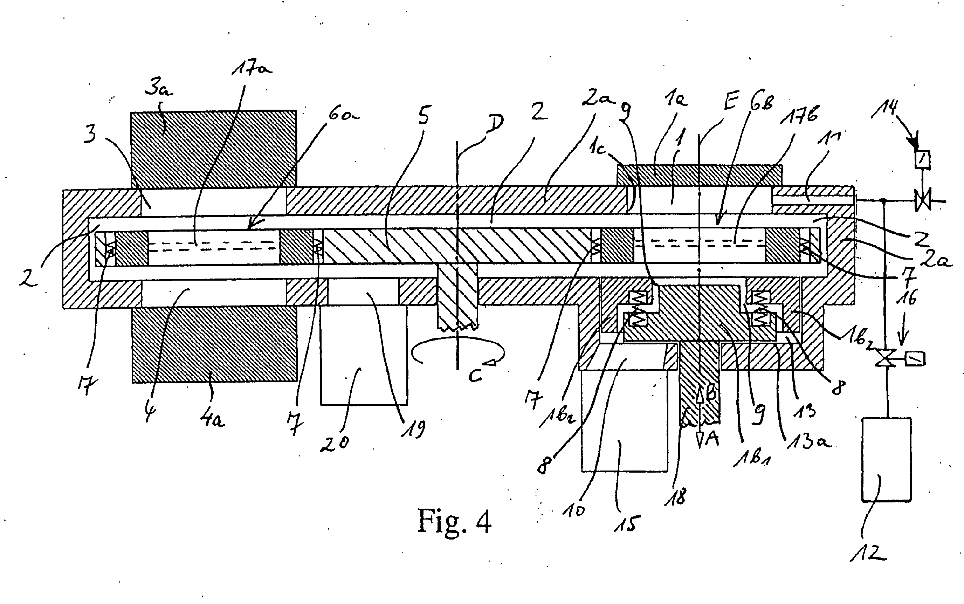

Nach Erreichen annähernd des gleichen Vakuums in der Schleuse 1 wie in der Transportkammer und den Prozeßkammern 3 und 4 wird der zweite Schleusendeckel 1b mit Hilfe der Kolbenstange 18 in Pfeilrichtung A um eine bestimmte Strecke weiter nach unten bewegt, jedoch vorzugsweise nicht auf den Boden 13a des Raumes 13 hinter (in der Zeichnung unten) dem inneren Schleusendeckel aufgesetzt, wobei der Hochvakuumkanal 9 durch die Druckkraft der Federn 8 geöffnet und in Verbindung mit dem Hochvakuumanschluß 10 bleibt. Durch geeignete Bemessung des Federwegs der Druckfedern 8 wird der zweite Substrathalter 6b dabei freigegeben und durch die Kraft der Federn 7 in die in Fig. 4 dargestellte Ruheposition im Substratträger 5 zurückgezogen.

Danach wird der zweite Substratträger 6b mit dem zu behandelnden Substrat 17b zu den Prozeßkammern 3 und 4 und der erste Substrathalter 6a mit dem behandelten Substrat 17a zur Schleuse 1 durch eine Drehbewegung des Substratträgers 5 in Pfeilrichtung C um die Achse D transportiert. In den Prozeßkammern 3, 4, der Transportkammer 2 und der Schleuse 1 wird über den Hochvakuumkanal 9 und den Hochvakuumpumpenanschluß 10 durch die Hochvakuumpumpe 15 sowie über den Hochvakuumpumpenanschluß 19 durch die Hochvakuumpumpe 20 ein Hochvakuum aufrecht erhalten. Dieser Zustand ist in Figur 4 dargestellt.

Zur Entnahme des behandelten Substrats wird mit Hilfe der Kolbenstange 18 und dem zweiten Schleusendeckel 1b der erste Substrathalter 6a in Pfeilrichtung B gegen die Öffnung 1c der Schleuse 1 andichtend gedrückt. Dadurch sind die Prozeßkammern 3, 4, die Transportkammer 2 und der Raum 13 hinter dem zweiten Schleusendeckel 1b gegenüber der Schleuse abgeschlossen (Fig. 1). Die Schleuse 1 wird bei geschlossenem Ventil 16 durch das Ventil 14 belüftet, und nach Abheben des ersten Schleusendeckels 1a kann das behandelte Substrat 17a entnommen und ein neues zu behandelndes Substrat in den Substrathalter eingelegt werden. Danach kann das oben anhand der Figuren 1 bis 4 dargestellte Verfahren wiederholt werden.

Der Substratträger (Drehteller) 5 kann mehr als zwei Substrathalter 6a, 6b, zum Beispiel fünf mit jeweils 72° Abstand auf dem Kreisumfang aufweisen, die auf die gleiche Weise wie die ersten zwei Substrathalter 6a bzw. 6b über Zugfedern mit dem Substratträger 5 verbunden sein können. Desweiteren kann der Substrathalter so konstruiert sein, daß er mehrere Substrate tragen kann, so daß mehrere Substrate gleichzeitig in dem ersten und zweiten Prozeßraum 3 bzw. 4 behandelt werden können.

## Patentansprüche

1. Vakuumschleusenanordnung mit:
(a) einer Schleuse (1) mit einem Belüftungs- Vakuumpumpenanschluß (11);
(b) einer Hochvakuumkammer (2); wobei
(c) die Schleuse (1) einen äußeren Schleusendeckel (1a) und einen inneren Schleusendeckel (1b) zum Verschließen der Schleuse (1) gegen die Hochvakuumkammer (2) aufweist,
**dadurch gekennzeichnet, daß**
(d) der innere Schleusendeckel (1b) ein erstes Teil (1b₁) und ein zweites Teil (1b₂) aufweist, die durch Federn (8) miteinander verbunden sind und bei unbelasteten Federn (8) zwischen sich einen ersten Hochvakuumkanal (9) ausbilden, der die Schleuse (1) mit einem ersten Hochvakuumsanschluß (10) verbindet.

2. Vakuumschleusenanordnung nach Anspruch 1, wobei die Hochvakuumkammer als Transportkammer (2) ausgebildet ist, in der eine Transporteinrichtung (5) zum Transportieren mindestens eines Substrats (17a, 17b) angeordnet ist.

3. Vakuumschleusenanordnung nach Anspruch 2, wobei die Transporteinrichtung ein als Drehteller ausgebildeter Substratträger (5) ist und mindestens ein erster und ein zweiter Substrathalter (6a bzw. 6b) vorgesehen sind, die bewegbar mit dem Substratträger (5) verbunden sind.

4. Vakuumschleusenanordnung nach Anspruch 3, wobei der Substrathalter (6a, 6b) gegen die Öffnung (1c) der Schleuse (1) durch den inneren Schleusendeckel mittels einer Hubstange (18) drückbar ist, so daß der Substrathalter (6a, 6b) und der innere Schleusendeckel (1b) die Transportkammer (2) gegen die Schleuse (1) verschieben.

5. Vakuumschleusenanordnung nach Anspruch 4, wobei mit der Transportkammer (2) mindestens eine erste Prozeßkammer (3) für Hochvakuum verbunden ist.

6. Vakuumschleusenanordnung nach Anspruch 5, wobei eine zweite Prozeßkammer (4) der ersten Prozeßkammer (3) gegenüberliegend auf der anderen Seite der Transporteinrichtung (5) angeordnet ist.

7. Vakuumschleuseneinrichtung nach Anspruch 5, wobei eine zweite Prozeßkammer auf der anderen Seite der Transporteinrichtung (5) und bezüglich der Drehachse D in Azimutrichtung versetzt zur ersten Prozeßkammer (3) angeordnet ist.

8. Vakuumschleusenanordnung nach Anspruch 5, 6 oder 7, wobei der Substratträger (5) um eine Schwenkachse (D) in Schwenkrichtung (C) zwischen der Schleuse (1) und der mindestens einen Prozeßkammer (3) hin und her bewegbar ist.

9. Vakuumschleusenanordnung nach einem der Ansprüche 1 bis 8, wobei der erste Hochvakuumpumpenanschluß (10) in Richtung (A) hinter dem zweiten Schleusendeckel (1b) angeordnet ist.

10. Vakuumschleusenanordnung nach einem der Ansprüche 7 bis 9, wobei die Transportkammer (2) einen zweiten Hochvakuumpumpenanschluß (19) mit einer zweiten Hochvakuumpumpe (20) aufweist.

11. Vakuumschleusenanordnung nach einem der Ansprüche 3 bis 10, wobei die ersten und zweiten Substrathalter (6a bzw. 6b) durch Federn (7) mit dem Substratträger (5) verbunden sind.

12. Vakuumschleusenanordnung nach einem der Ansprüche 1 bis 11, wobei die Federn (7, 8) vorgespannte Druckfedern oder Zugfedern sind, die vorzugsweise durch Membranfedern geführt werden.

13. Vakuumschleusenanordnung nach einem der Ansprüche 1 bis 12, wobei die Hochvakuumpumpenanschlüsse (10, 19) an Turbomolekularpumpen (15 bzw. 20) angeschlossen sind.

14. Verfahren zum Transportieren eines Objekts in einer Transportkammer unter Vakuumbedingungen zwischen einer Schleuse und einem ersten und zweiten Prozeßraum mittels der Vakuumschleusenanordnung nach einem der Ansprüche 6 bis 13, mit den Schritten:
(a) Einlegen mindestens eines Substrats (17b) in den zweiten Substrathalter (6b) in der Schleuse (1) in einer Stellung (B) des inneren Schleusendeckels (1b), wobei das Hochvakuum der Transportkammer (2) durch den zweiten Substrathalter (6b) und den inneren Schleusendeckel (1b) und das Hochvakuum eines Raumes (13) mit dem ersten Hochvakuumpumpenanschluß (10) hinter dem inneren Schleusendeckel (1b) durch den inneren Schleusendeckel (1b) gegen die Schleuse abgedichtet ist;
(b) Verschließen der Schleuse (1) durch den äußeren Schleusendeckel (1a);
(c) Evakuieren der Schleuse (1) auf Vorvakuum durch eine Vorvakuumpumpe (12) über den Belüftungs- Vorvakuumpumpenkanal (11);
(d) Entlasten der Federn (8), so daß das erste Teil (1b₁) des inneren Schleusendeckels (1b) sich von dem zweiten Teil (1b₂) weg bewegt, wobei sich der Hochvakuumkanal (9) öffnet und das Gasvolumen aus der Schleuse (1) in den Raum (13) hinter dem zweiten Schleusendeckel (1b) expandiert und über den ersten Hochvakuumpumpenanschluß (10) durch die erste Hochvakuumpumpe (15) abgesaugt wird, und wobei das zweite Teil (1b₂) durch die Kraft der Federn (8) den zweiten Substrathalter (6b) gegen die Öffnung (1c) der Schleuse (1) gedrückt hält und der zweite Teil (1b₂) und der zweite Substrathalter (6b) die Transportkammer (2) und die Prozeßkammern (3, 4) gegen die Schleuse (1) weiterhin verschlossen halten;
(e) Bewegen des zweiten Schleusendeckels (1b) um eine bestimmte Strecke in Richtung des Bodens (13a) des Raumes (13) nachdem in der Schleuse (1) im wesentlichen das gleiche Vakuum wie in der Transportkammer (2) und den Prozeßkammern (3, 4) erreicht wurde, wobei der zweite Substrathalter (6b) auf den Substratträger (5) zurückgezogen und in der Schleuse (1), der Transportkammer (2) und den Prozeßkammern (3, 4) durch den zweiten Hochvakuumpumpenanschluß (19) und den offenen Hochvakuumkanal (9) über den ersten Hochvakuumpumpenanschluß (10) das Hochvakuum aufrecht erhalten wird;
(f) Transportieren des zweiten Substrathalters (6b) mit dem zu behandelnden Substrat (17b) zu der ersten und zweiten Prozeßkammer (3 bzw. 4) und des ersten Substrathalters mit einem behandelten Substrat (17a) zur Schleuse (1);
(g) Heranfahren des inneren Schleusendeckels (1b) an den ersten Substrathalter (6a) und Andrücken des ersten Substrathalters (6a) an die Öffnung (1c) der Schleuse (1), wobei die Prozeßkammern (3, 4), die Transportkammer (2) und der Hochvakuumkanal (9) gegen die Kraft der Federn (8) gegenüber der Schleuse (1) verschlossen werden;
(h) Belüften der Schleuse (1) durch ein Ventil (14) über den Belüftungs-Vorvakuumkanal (11); und
(i) Entnehmen des Substrats (17a).

15. Verfahren nach Anspruch 14, wobei in Schritt (e) die Federn (7) den Substrathalter (6a, 6b) auf den Substratträger (5) zurückbewegen.

16. Verfahren nach Anspruch 14 oder 15, wobei in Schritt (c) ein Vorvakuum von 0,1 bis 3 mbar erzeugt wird.

17. Verfahren nach Anspruch 16, wobei in Schritt (c) ein Vorvakuum von 1 mbar erzeugt wird.

18. Verwendung der Vakuumschleusenanordnung nach einem der Ansprüche 1 bis 13 und des Verfahrens nach einem der Ansprüche 14 bis 17 bei der Beschichtung von CDs, DVDs, optischen Linsen und Brillengläsern.

19. Verwendung der Vakuumschleusenanordnung nach einem der Ansprüche 1 bis 13 und des Verfahrens nach einem der Ansprüche 14 bis 17 bei der Reinigung von CDs, DVDs, optischen Linsen und Brillengläsern.

## Claims

1. A vacuum lock arrangement comprising:
(a) a lock (1) comprising a ventilation vacuum pump connection (11);
(b) a high-vacuum chamber (2); wherein
(c) the lock (1) comprises an outer lock cover (1a) and an inner lock cover (1b) for closing the lock (1) towards the high-vacuum chamber (2),
**characterized in that**
(d) the inner lock cover (1b) comprises a first part (1b₁) and a second part (1b₂) which are connected by means of springs (8) and which form a first high-vacuum channel (9) between them if the springs (8) are unloaded, the first high-vacuum channel (9) connecting the lock (1) with a first high-vacuum connection (10).

2. The vacuum lock arrangement according to claim 1, wherein the high-vacuum chamber is configured as a transport chamber (2) in which a transport means (5) for transporting at least one substrate (17a, 17b) is arranged.

3. The vacuum lock arrangement according to claim 2, wherein the transport means is a substrate support (5) that is configured as a rotary table, and at least a first and a - second substrate holder (6a and 6b, respectively) which are movably connected with the substrate support (5) are provided.

4. The vacuum lock arrangement according to claim 3, wherein the substrate holder (6a, 6b) can be pressed against the opening (1c) of the lock (1) via the inner lock cover by means of a lifting rod (18) so that the substrate holder (6a, 6b) and the inner lock cover (1b) close the transport chamber (2) towards the lock (1).

5. The vacuum lock arrangement according to claim 4, wherein at least one first process chamber (3) for high-vacuum is connected with the transport chamber (2).

6. The vacuum lock arrangement according to claim 5, wherein a second process chamber (4) is arranged on the other side of the transport means (5) so as to face the first process chamber (3).

7. The vacuum lock arrangement according to claim 5, wherein a second process chamber is arranged on the other side of the transport means (5) and offset with respect to the first process chamber (3) relative to the rotational axis D in azimuth direction.

8. The vacuum lock arrangement according to claim 5, 6 or 7, wherein the substrate support (5) can be moved to and fro between the lock (1) and the at least one process chamber (3) around a swivel axis (D) in the swiveling direction (C).

9. The vacuum lock arrangement according to any one of claims 1 to 8, wherein the first high-vacuum pump connection (10) is arranged in the direction (A) behind the second lock cover (1b).

10. The vacuum lock arrangement according to any one of claims 7 to 9, wherein the transport chamber (2) comprises a second high-vacuum pump connection (19) with a second high-vacuum pump (20).

11. The vacuum lock arrangement according to any one of claims 3 to 10, wherein the first and second substrate holders (6a and 6b, respectively) are connected by means of springs (7) with the substrate support (5).

12. The vacuum lock arrangement according to any one of claims 1 to 11, wherein the springs (7, 8) are pre-stressed pressure springs or tension springs which are preferably guided by membrane springs.

13. The vacuum lock arrangement according to any one of claims 1 to 12, wherein the high-vacuum pump connections (10, 19) are connected with turbomolecular pumps (15 and 20, respectively).

14. A method for transporting an object in a transport chamber under vacuum conditions between a lock and first and second process chambers by means of the vacuum lock arrangement according to any one of claims 6 to 13, the method comprising the steps of:
(a) placing at least one substrate (17b) into the second substrate holder (6b) in the lock (1) in a position (B) of the inner lock cover (1b), wherein the high-vacuum of the transport chamber (2) is sealed by means of the second substrate holder (6b) and the inner lock cover (1b), and the high-vacuum of a space (13) with the first high-vacuum pump connection (10) behind the inner lock cover (1b) are sealed by means of the inner lock cover (1b) towards the lock;
(b) closing the lock (1) by means of the outer lock cover (1a);
(c) evacuating the lock (1) to a pre-vacuum by means of a pre-vacuum pump (12) through the ventilation pre-vacuum pump channel (11);
(d) unloading the springs (8) so that the first part (1b₁) of the inner lock cover (1b) moves away from the second part (1b₂), wherein the high-vacuum channel (9) opens and the gas volume expands from the lock (1) into the space (13) behind the second lock cover (1b) and is sucked off through the first high-vacuum pump connection (10) by means of the first high-vacuum pump (15), and wherein the second part (1b₂) keeps the second substrate holder (6b) pressed against the opening (1c) in the lock (1) by means of the force of the springs (8), and the second part (1b₂) and the second substrate holder (6b) keep the transport chamber (2) and the process chambers (3, 4) closed towards the lock (1);
(e) moving the second lock cover (1b) by a predetermined distance in the direction of the bottom (13a) of the space (13) after essentially the same vacuum as in the transport chamber (2) and the process chambers (3, 4) has been reached in the lock (1), wherein the second substrate holder (6b) is retracted to the substrate support (5) and the high-vacuum is maintained in the lock (1), the transport chamber (2) and the process chambers (3, 4) by the second high-vacuum pump connection (19) and via the open high-vacuum channel (9) by the first high-vacuum pump connection (10);
(f) transporting the second substrate holder (6b) with the substrate (17b) to be treated to the first and second process chambers (3 and 4, respectively) and the first substrate holder with the treated substrate (17a) to the lock (1);
(g) moving the inner lock cover (1b) to the first substrate holder (6a) and pressing the first substrate holder (6a) against the opening (1c) of the lock (1), wherein the process chambers (3, 4), the transport chamber (2) and the high-vacuum channel (9) are closed towards the lock (1) against the force of the springs (8);
(h) ventilating the lock (1) by means of a valve (14) through the ventilation pre-vacuum channel (11); and
(i) removing the substrate (17a).

15. The method according to claim 14, wherein in step (e) the springs (7) move the substrate holder (6a, 6b) back onto the substrate support (5).

16. The method according to claim 14 or 15, wherein a pre-vacuum of 0.1 to 3 mbar is generated in step (c).

17. The method according to claim 16, wherein a pre-vacuum of 1 mbar is generated in step (c).

18. Use of the vacuum lock arrangement according to any one of claims 1 to 13 and the method according to any one of claims 14 to 17 for coating CDs, DVDs, optical lenses and eyeglass lenses.

19. Use of the vacuum lock arrangement according to any one of claims 1 to 13 and the method according to any one of claims 14 to 17 for cleaning CDs, DVDs, optical lenses and eyeglass lenses.

## Revendications

1. Système de sas sous vide, comportant :
(a) un sas (1) avec un raccord de ventilation ou de pompe à vide (11) ;
(b) une chambre à vide poussé (2) ;
(c) le sas (1) étant muni d'un couvercle de sas extérieur (1a) et d'un couvercle de sas intérieur (1b) pour fermer le sas (1) vers la chambre à vide poussé (2) ;
**caractérisé en ce que**
(d) le couvercle de sas intérieur (1b) comporte une première partie (1b₁) et une deuxième partie (1b₂), qui sont assemblées l'une à l'autre par des ressorts (8) et qui, lorsque les ressorts (8) ne sont pas sollicités, forment entre elles un premier conduit de vide poussé (9), par lequel le sas (1) communique avec un premier raccord de pompe à vide poussé (10).

2. Système de sas sous vide selon la revendication 1, dans lequel la chambre à vide poussé est conçue sous forme de chambre de transport (2), dans laquelle est agencé un dispositif de transport (5) destiné à transporter au moins un substrat (17a, 17b).

3. Système de sas sous vide selon la revendication 2, dans lequel le dispositif de transport est un support de substrats (5), conçu sous forme de plateau rotatif, et il est prévu au moins un premier et un deuxième porte-substrat (6a et 6b) qui sont reliés de manière mobile au support de substrats (5).

4. Système de sas sous vide selon la revendication 3, dans lequel le porte-substrat (6a, 6b) peut être poussé contre l'ouverture (1c) du sas (1) par le couvercle de sas intérieur au moyen d'une barre de levage (18), de telle sorte que le porte-substrat (6a, 6b) et le couvercle de sas intérieur (1b) ferment la chambre de transport (2) vers le sas (1).

5. Système de sas sous vide selon la revendication 4, dans lequel au moins une première chambre opératoire (3) pour le vide poussé est reliée à la chambre de transport (2).

6. Système de sas sous vide selon la revendication 5, dans lequel une deuxième chambre opératoire (4), située en face de la première chambre opératoire (3), est agencée sur l'autre côté du dispositif de transport (5).

7. Système de sas sous vide selon la revendication 5, dans lequel une deuxième chambre opératoire est agencée sur l'autre côté du dispositif de transport (5) et est décalée par rapport à la première chambre opératoire (3) dans le sens azimutal par rapport à l'axe de rotation D.

8. Système de sas sous vide selon la revendication 5, 6 ou 7, dans lequel le support de substrats (5) est apte à se déplacer en va-et-vient autour d'un axe de pivotement (D) dans le sens de pivotement (C) entre le sas (1) et ladite au moins une chambre opératoire (3).

9. Système de sas sous vide selon l'une quelconque des revendications 1 à 8, dans lequel le premier raccord de pompe à vide poussé (10) est agencé dans la direction (A) en aval du deuxième couvercle de sas (1b).

10. Système de sas sous vide selon l'une quelconque des revendications 7 à 9, dans lequel la chambre de transport (2) comporte un deuxième raccord (19) pour une deuxième pompe à vide poussé (20).

11. Système de sas sous vide selon l'une quelconque des revendications 3 à 10, dans lequel les premiers et les deuxièmes porte-substrat (6a et 6b) sont reliés au support de substrats (5) par l'intermédiaire de ressorts (7).

12. Système de sas sous vide selon l'une quelconque des revendications 1 à 11, dans lequel les ressorts (7, 8) sont des ressorts de pression ou ressorts de traction précontraints, qui sont guidés de préférence à travers des ressorts à membrane.

13. Système de sas sous vide selon l'une quelconque des revendications 1 à 12, dans lequel les raccords de pompe à vide poussé (10, 19) sont raccordés à des turbopompes moléculaires (15 et 20).

14. Procédé pour transporter un objet dans une chambre de transport dans des conditions de vide entre un sas et une première et une deuxième chambre opératoire au moyen du système de sas sous vide selon l'une quelconque des revendications 6 à 13, comportant les étapes :
(a) introduction d'au moins un substrat (17b) dans le deuxième porte-substrat (6b) dans le sas (1) dans une position (B) du couvercle de sas intérieur (1b), le vide poussé dans la chambre de transport (2) étant rendu étanche vers le sas par le deuxième porte-substrat (6b) et le couvercle de sas intérieur (1b), et le vide poussé dans une enceinte (13) munie du premier raccord de pompe à vide poussé (10) en aval du couvercle de sas intérieur (1b) étant rendu étanche vers le sas par le couvercle de sas intérieur (1b) ;
(b) fermeture du sas (1) par le couvercle de sas extérieur (1a) ;
(c) production d'un vide préliminaire dans le sas (1) par une pompe à vide préliminaire (12) par l'intermédiaire du conduit de ventilation ou de pompe à vide préliminaire (11) ;
(d) détente des ressorts (8), de telle sorte que la première partie (1b₁) du couvercle de sas intérieur (1b) se déplace en s'écartant de la deuxième partie (1b₂), le conduit à vide poussé (9) s'ouvrant et le volume de gaz se propageant hors du sas (1) dans l'enceinte (13) en aval du deuxième couvercle de sas (1b) et étant aspiré par la première pompe à vide poussé (15) par l'intermédiaire du premier raccord de pompe à vide poussé (10), et la deuxième partie (1b₂), sous l'effet de la force des ressorts (8), maintenant le deuxième porte-substrat (6b) pressé contre l'ouverture (1c) du sas (1) et la deuxième partie (1b₂) et le deuxième porte-substrat (6b) maintenant la chambre de transport (2) et les chambres opératoires (3, 4) fermées vers le sas (1) ;
(e) déplacement du deuxième couvercle de sas (1b) sur une distance déterminée vers le fond (13a) de l'enceinte (13) une fois que le vide dans le sas (1) est devenu sensiblement identique au vide dans la chambre de transport (2) et les chambres opératoires (3, 4), le deuxième porte-substrat (6b) étant retiré vers l'arrière sur le support de substrats (5) et le vide poussé étant maintenu dans le sas (1), la chambre de transport (2) et les chambres opératoires (3, 4) par le deuxième raccord de pompe à vide poussé (19) et le conduit à vide poussé (9) ouvert, par l'intermédiaire du premier raccord de pompe à vide poussé (10) ;
(f) transport du deuxième porte-substrat (6b) avec le substrat (17b) à traiter vers la première et la deuxième chambre opératoire (3 et 4) et transport du premier porte-substrat avec un substrat (17a) traité vers le sas (1) ;
(g) déplacement du couvercle de sas intérieur (1b) contre le premier porte-substrat (6a) et pression du premier porte-substrat (6a) contre l'ouverture (1c) du sas (1), les chambres opératoires (3, 4), la chambre de transport (2) et le conduit à vide poussé (9) étant fermés vers le sas (1) à l'encontre de la force des ressorts (8) ;
(h) ventilation du sas (1) par une vanne (14) par l'intermédiaire du conduit de ventilation à vide préliminaire (11) ; et
(i) prélèvement du substrat (17a).

15. Procédé selon la revendication 14, dans lequel dans l'étape (e) les ressorts (7) repoussent le porte-substrat (6a, 6b) sur le support de substrats (5).

16. Procédé selon la revendication 14 ou 15, dans lequel un vide préliminaire de 0,1 à 3 mbar est généré dans l'étape (c).

17. Procédé selon la revendication 16, dans lequel un vide préliminaire de 1 mbar est généré dans l'étape (c).

18. Utilisation du système de sas sous vide selon l'une quelconque des revendications 1 à 13, et du procédé selon l'une quelconque des revendications 14 à 17 lors du revêtement de CD, DVD, lentilles optiques et verres optiques.

19. Utilisation du système de sas sous vide selon l'une quelconque des revendications 1 à 13, et du procédé selon l'une quelconque des revendications 14 à 17 lors du nettoyage de CD, DVD, lentilles optiques et verres optiques.
